# EUROPEAN PATENT SPECIFICATION

(11) **EP 0 526 728 B1**
(45) Date of publication and mention of the grant of the patent: **22.05.1996**
(21) Application number: 92110774.4
(22) Date of filing: 26.06.1992
(51) Int. Cl.: C04B 38/00, H01L 41/04, H01L 41/187, H01L 41/22

(54) **Piezoelectric element**
Piezoelektrisches Element
Elément piezoélectrique

(30) Priority: 05.07.1991 JP 192466/91; 05.07.1991 JP 192467/91; 05.07.1991 JP 192468/91
(43) Date of publication of application: 10.02.1993
(73) Proprietor: MURATA MANUFACTURING CO., LTD., Nagaokakyo-shi Kyoto-fu 226 (JP)
(72) Inventor: Nakamura, Takeshi, c/o Murata Manufac. Co.,Ltd., Nagaokakyo-shi, Kyoto-fu (JP); Amano, Tsuneo, c/o Murata Manufac. Co.,Ltd., Nagaokakyo-shi, Kyoto-fu (JP); Iwai, Kiyoshi, c/o Murata Manufac. Co.,Ltd., Nagaokakyo-shi, Kyoto-fu (JP); Kamada, Kazuya, c/o Murata Manufac. Co.,Ltd., Nagaokakyo-shi, Kyoto-fu (JP)
(74) Representative: Schoppe, Fritz, Dipl.-Ing.

(56) References cited:
- EP-A- 0 150 363
- EP-A- 0 171 716
- EP-A- 0 262 248
- EP-A- 0 379 576
- WO-A-90/10609
- DE-A- 3 409 815
- GB-A- 2 068 355
- US-A- 4 786 837
- PATENT ABSTRACTS OF JAPAN, vol. 016, no. 431 (C-0983) 9 September 1992 & JP-A-04 149 078
- PATENT ABSTRACTS OF JAPAN, vol. 013, no. 447 (C-642) 6 October 1989 & JP-A-01 172 281
- DATABASE WPI, Section Ch, Week 8631, Derwent Publications Ltd., London, GB; Class A85, AN 86-202610 & JP-A-61 136 973
- PATENT ABSTRACTS OF JAPAN, vol. 012, no. 077 (E-589) 10 March 1988 & JP-A-62 216 412

## Description

The present invention relates to a vibrating gyroscope comprising a vibrator having a regular cross-section defined by at least three side surfaces and piezoelectric elements, each of said piezoelectric elements being fixed to one of said at least three side surfaces and each of said piezoelectric elements comprising a piezoelectric body having electrodes formed on both main surfaces thereof.

### Description of the Prior Art

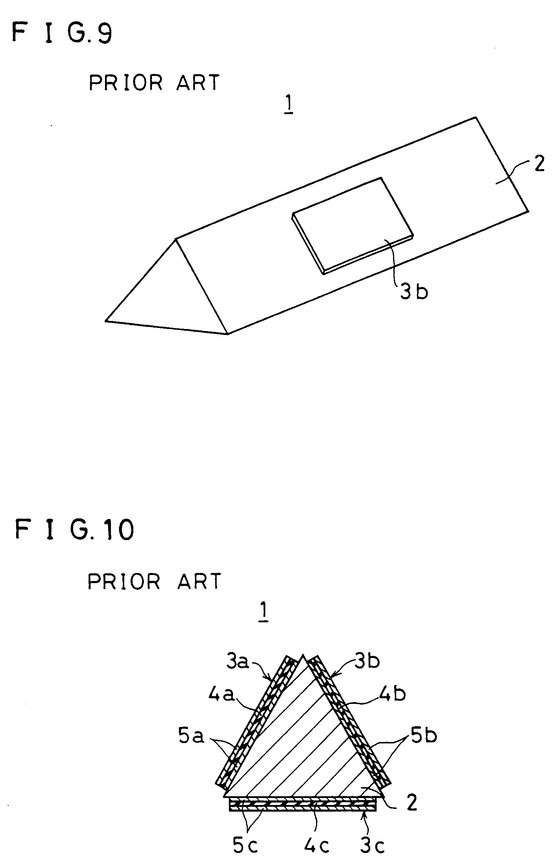

Fig. 9 is a perspective view showing an angular velocity sensor using a conventional piezoelectric element which is a background of the present invention, and Fig. 10 is its sectional view. The angular velocity sensor 1 comprises a vibrator 2 formed with a material which generates a mechanical vibration such as elinvar. The vibrator 2 is formed into a triangular prism shape and on side faces thereof, three piezoelectric elements 3a, 3b and 3c are formed. The piezoelectric elements 3a, 3b and 3c include piezoelectric bodies 4a, 4b and 4c, on both surfaces of which electrodes 5a, 5b and 5c are formed. One sides or surfaces of the electrodes 5a, 5b and 5c are respectively bonded to the side faces of the vibrator 2.

When using the angular velocity sensor 1, for example, an oscillation circuit is connected between the piezoelectric elements 3a, 3b and the piezoelectric element 3c. The vibrator 2 bends and vibrates in a direction orthogonal to the surface whereon the piezoelectric element 3c is formed, by an output signal from the oscillation circuit. When rotating about an axis of the angular velocity sensor 1, output voltages are generated in the piezoelectric elements 3a and 3b. A rotational angular velocity applied to the angular velocity sensor 1 is measured by measuring the output voltage difference from the piezoelectric elements 3a and 3b.

In the piezoelectric element used in such an angular velocity sensor, however, since the electrode is formed on the surface of the piezoelectric body, by the difference in thermal expansion coefficients between the piezoelectric body and the electrode, the piezoelectric element is bend and distorted by the change in atmospheric temperature. The piezoelectric element is also bend and distorted by the change in atmospheric temperature, by the difference in thermal expansion coefficients between the vibrator and the piezoelectric element. By these reasons, voltages other than the voltage responsive to the rotational angular velocity are generated and characteristics of the angular velocity sensor is liable to fluctuate.

Patent Abstracts of Japan, Volume 13, No. 447, corresponding to JP-A-1172281 discloses a porous piezoelectric material for piezoelectric vibrators having holes in such a manner that the pores form 23 to 45% voids of the whole volume of the vibrator.

EP-A-171716 discloses a piezoelectric ceramic material adapted for ultrasonic converters formed by porous piezoelectric ceramics having a porosity between 10% and 50%.

GB-A-2068355 discloses a ceramic material for piezoelectric ceramic elements having freely selectable porosities between 6% and 54%.

The present invention is based on the object of reducing undesired temperature fluctuations of the output voltage a vibrating gyroscope.

This object is achieved by a vibrating gyroscope in accordance with claim 1.

By forming the pores in the piezoelectric element, difference in thermal expansion coefficients between the piezoelectric element and the vibrator is reduced and the bend and distortion of the piezoelectric element are lessened.

According to the present invention, even when the atmospheric temperature has changed, the bend and distortion of the piezoelectric elements due to difference in thermal expansion coefficients between the vibrator and the piezoelectric elements hardly occur, and the unnecessary voltage is hardly generated.

The above and other objects, features, aspects and advantages of the present invention will become more apparent from the following detailed description of the embodiment made with reference to the drawings.

### BRIEF DESCRIPTION OF THE DRAWINGS

Fig. 1 is a perspective view showing one embodiment of the present invention.

Fig. 2 is a sectional view of an angular velocity sensor shown in Fig. 1.

Fig. 3 is a block diagram showing a circuit when the angular velocity sensor shown in Fig. 1 is used.

Fig. 4 is a perspective view showing another embodiment of the angular velocity sensor shown in Fig. 1.

Fig. 5 is a sectional view of the angular velocity sensor shown in Fig. 4.

Fig. 6 is a perspective view showing another embodiment of the present invention.

Fig. 7 is a sectional view of an angular velocity sensor shown in Fig. 6.

Fig. 8 is a block diagram showing a circuit when the angular velocity sensor showing in Fig. 6 is used.

Fig. 9 is a perspective view showing an angular velocity sensor using a conventional piezoelectric element which is a background of the present invention.

Fig. 10 is a sectional view of the angular velocity sensor shown in Fig. 9.

### DESCRIPTION OF THE PREFERRED EMBODIMENTS

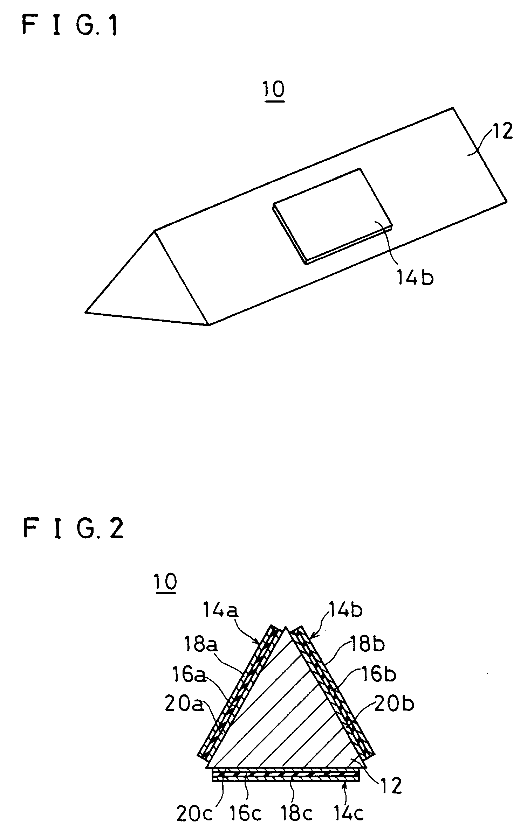

Fig. 1 is a perspective view showing an angular velocity sensor which uses a piezoelectric element of the present invention, and Fig. 2 is its sectional view. The angular velocity sensor 10 comprises an vibrator 12. The vibrator 12 is formed into a regular triangular prism shape with a material which produces a mechanical vibration such as elinver. On center portions of three side faces of the vibrator 12, piezoelectric elements 14a, 14b and 14c are formed respectively. The piezoelectric element 14a includes a piezoelectric body 16a, on both surfaces of which electrodes 18a and 20a are formed. One electrode 20a is bonded to a side face of the vibrator 12. Similarly, the piezoelectric elements 14b, 14c include piezoelectric bodies 16b, 16c, on both surfaces of which electrodes 18b, 20b and electrodes 18c, 20c are formed. To side faces of the vibrator 12, the electrodes 20b and 20c are bonded.

As the piezoelectric elements 14a, 14b and 14c, those having internal pores are used. For forming the pores in the piezoelectric body, for example, an inflammable material such as a cellulose is mixed into piezoelectric ceramic material. By molding and firing the materials, the piezoelectric body is formed. At this time, the cellulose is burnt and the pores are formed in the piezoelectric body. The piezoelectric body having the pores may be formed by molding and firing the foamed piezoelectric ceramic materials. Moreover, the piezoelectric body having the pores may be formed by sticking a fine needle into the piezoelectric ceramic materials to form gaps therein and firing the same. Meanwhile, the pores may be formed by forming gaps between the material particles by controlling the particle size of the piezoelectric ceramic materials and firing the same.

Then, the piezoelectric elements 14a, 14b and 14c were formed by changing the porosity. The piezoelectric elements 14a, 14b and 14c were bonded to the vibrator 12 to manufacture the angular velocity sensor 10.

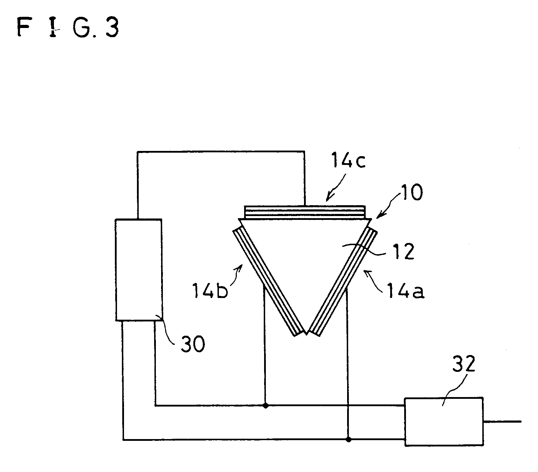

To examine characteristics of the angular velocity sensor 10, as shown in Fig. 3, an oscillation circuit 30 is connected between the piezoelectric elements 14a, 14b and the piezoelectric element 14c. Then, the vibrator 12 is vibrated by a signal from the oscillation circuit 30. In this case, the vibrator 12 bends and vibrates in a direction orthogonal to a surface onto which the piezoelectric element 14c is bonded. By rotating about an axis of the vibrator 12 and using a differential circuit 32, difference in output voltages of the piezoelectric elements 14a and 14b was measured. For the angular velocity sensor using the piezoelectric elements having the different porosity, atmospheric temperature was changed in the range of -20°C to +85°C for such measurement, and the rate of change in output voltage due to the atmospheric temperature change was examined. The results are shown in Table 1.

As it is shown in Table 1, in the angular velocity sensor 10 using the piezoelectric elements 14a, 14b and 14c whose porosity is in the range of 5 to 50%, the rate of change in output voltage at the atmospheric temperature change is small. Particularly, it is preferable to use the piezoelectric element whose porosity is in the range of 5 to 20%, because the rate of change in output voltage is small. When the porosity of the piezoelectric element is 5% or less, it is less effective in restraining the bend and distortion of the piezoelectric element due to difference in thermal expansion coefficients between the vibrator 12 and the piezoelectric elements 14a, 14b and 14c, and the rate of change in output voltage becomes larger. When the porosity of the piezoelectric element exceeds 50%, it is apt to absorb atmospheric moisture. Furthermore, when the piezoelectric elements 14a, 14b and 14c are bonded to the vibrator 12, an adhesive is apt to soak into the pores. By these reasons, when the porosity is excessively large, the rate of change in output voltage of the angular velocity sensor becomes larger. When the porosity is excessively large, the mechanical strength of the piezoelectric element is weakened and is liable to break.

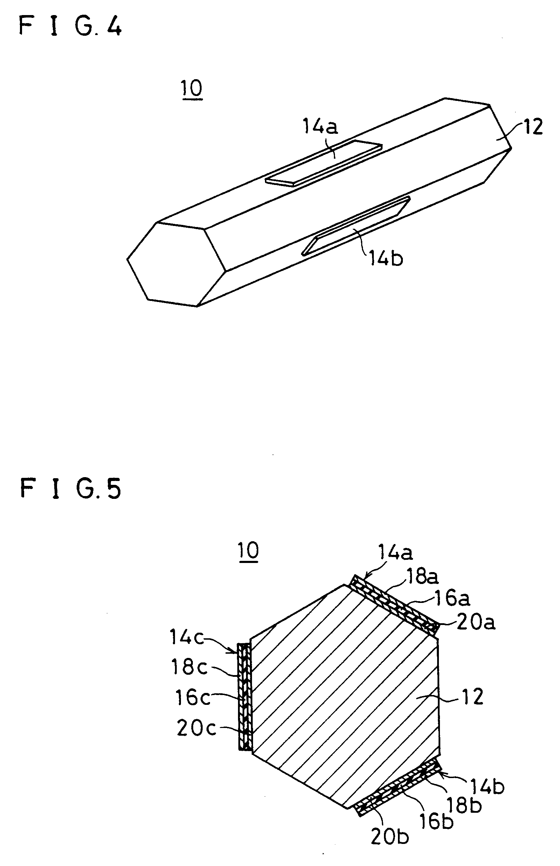

Next, as shown in Fig. 4 and Fig. 5, to the center portions on three alternate side faces of a hexagonal prism-shaped vibrator 12, the piezoelectric elements 14a, 14b and 14c were bonded to manufacture an angular velocity sensor 10. In a same manner as the above-mentioned embodiment, difference in output voltages from the piezoelectric elements 14a and 14b was measured. In this embodiment, the rate of change in the output voltage was examined, by changing the porosity of respective piezoelectric elements and changing atmospheric temperature in the range of -20°C to +85°C. The results are shown in Table 2.

As it is shown in Table 2, also in this embodiment, the rate of change in the output voltages of the angular velocity sensor using the piezoelectric element whose porosity is 5 to 50% was small. When the piezoelectric element whose porosity is 5 to 20% is used, particularly, the rate of change in the output voltages is small.

As such, by making the porosity of the piezoelectric element 5 t0 50%, the rate of change in the output voltages of the angular velocity sensor 10 against the atmospheric temperature change can be made smaller. Particularly, it is very effective when the porosity of the piezoelectric element is in the range of 5 to 20%. Though the triangular and hexagonal prisms were used as the vibrator in the above-mentioned embodiments, as a shape of the vibrator, this effect can be obtained even when it is formed into the other prism shape such as an octagonal prism shape.

In order to prevent the bend of the piezoelectric element due to difference in thermal expansion coefficients between the piezoelectric body and the electrode, the electrodes of the piezoelectric elements 14a, 14b and 14c may be formed by vacuum evaporation or plating. For obtaining such piezoelectric elements 14a, 14b and 14c, first the piezoelectric bodies 16a, 16b and 16c are formed. The piezoelectric bodies 16a, 16b and 16c of the piezoelectric elements 14a, 14b and 14c are formed by molding, for example, piezoelectric ceramic materials into a plate or sheet shape and baking the same. The piezoelectric bodies 16a, 16b and 16c may not necessarily include the pores therein. The electrodes are formed on the surface of the piezoelectric bodies thus obtained by vacuum evaporation or plating using a metal, for example, Ag, Cu and the like. When the electrodes are formed in such a manner, as compared with a baking method, the electrodes can be formed at lower temperature. By forming the electrodes at low temperature, an excessive stress due to reactions of glass components in the electrode material is not exerted on the piezoelectric body as the case wherein the electrodes are formed by baking at higher temperature. Therefore, even when the atmospheric temperature has changed, a difference in expansion and contraction between the piezoelectric body and the electrodes is small and the bend and distortion are hardly occurred on the piezoelectric element. Thus, voltages other than the voltage responsive to the rotational angular velocity applied to the angular velocity sensor 10 are hardly generated and an accurate measurement can be accomplished.

As an experimental example an electrode was formed on a piezoelectric body by the methods of baking, vacuum evaporation and electroless plating to prepare piezoelectric elements 14a, 14b and 14c, which were used to form an angular velocity sensor 10.

Characteristics of the angular velocity sensor 10 was measured by the circuit shown in Fig. 3. In this experiment, the electrodes of the piezoelectric elements 14a, 14b and 14c were formed by changing the electrode material and the forming method, and for the angular velocity sensor using them, difference in output voltage of the piezoelectric elements 14a and 14b was measured by changing atmospheric temperature in the range of -25°C to 85°C to examine the rate of change in output voltage due to the atmospheric temperature change. An output drift and a standard deviation σ of the output voltage were measured, and the results are shown in Table 3.

As it is known from Table 3, in the case of using the piezoelectric element whose electrodes are formed by baking, the output drift and the standard deviation σ are large. On the contrary, in the case of using the piezoelectric element whose electrodes are formed by vacuum evaporation or electroless plating, the output drift and the standard deviation σ are small.

Also for the piezoelectric element of the present invention, it is possible to apply to the acceleration sensor, pressure sensor, displacement sensor and so on besides the angular velocity sensor and to improve accuracy of these sensors.

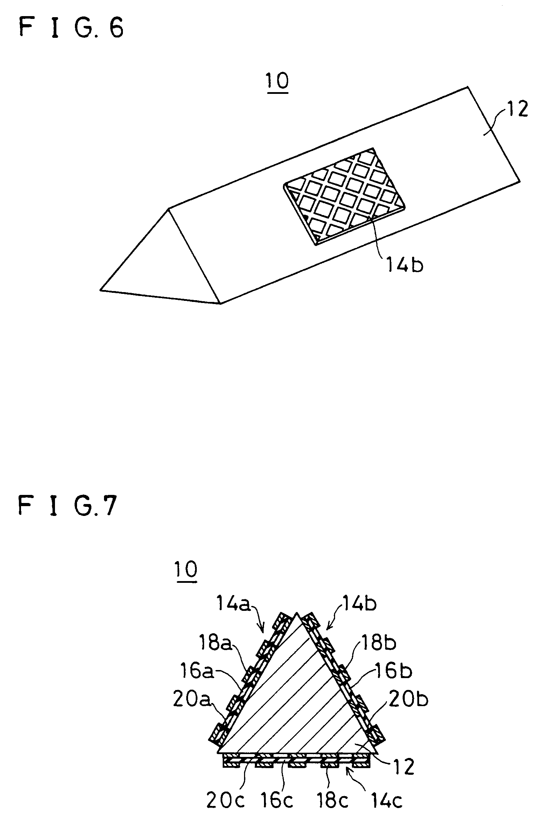

Meanwhile, as shown in Fig. 6 and Fig. 7, the electrodes 18a and 20a of the piezoelectric element 14a, the electrodes 18b and 20b of the piezoelectric element 14b and the electrodes 18c and 20c of the piezoelectric element 14c may be respectively formed into the reticular electrodes. In order to obtain such piezoelectric elements 14a, 14b and 14c, first, the piezoelectric bodies 16a, 16b and 16c are formed. The piezoelectric bodies 16a, 16b and 16c of the piezoelectric elements 14a, 14b and 14c are formed by molding, for example, a piezoelectric ceramic materials into a plate or sheet shape and firing the same. Also in this case, the piezoelectric bodies 16a, 16b and 16c may not necessarily include the pores therein. On the surface of the piezoelectric bodies thus obtained, a metal paste such as Ag-Pd is printed recticularly and baked to form the electrode.

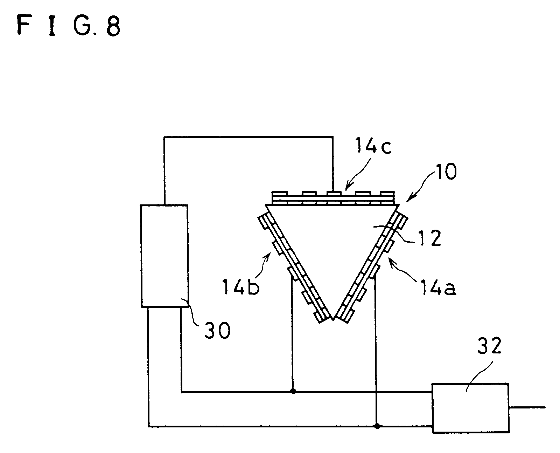

Also in the case of measuring the rotational angular velocity by using the angular velocity sensor 10, for example, as shown in Fig. 8, a circuit comprising the oscillation circuit 30 and the differential circuit 32 is used.

In this angular velocity sensor 10, by forming the electrode into a reticular shape, expansion and contraction of the reticular electrode due to the atmospheric temperature change is dispersed. And hence, even when atmospheric temperature has changed, an excessive stress is not exerted on the piezoelectric body. Therefore, even when atmospheric temperature has changed, the bend and distortion are hardly occurred on the piezoelectric body. Thus, voltages other than the voltage responsive to the rotational angular velocity applied to the angular velocity sensor 10 are hardly generated and an accurate measurement can be accomplished.

For such piezoelectric element, though the piezoelectric element of the present invention is applied to the angular velocity sensor, it is possible to apply this piezoelectric element to the acceleration sensor, pressure sensor, displacement sensor and so on, and to improve accuracy of these sensors.

**TABLE 1**

| POROSITY (%) | RATE OF CHANGE IN OUTPUT VOLTAGE (%) |
|---|---|
| BELOW 4 | 11 |
| 5∼10 | 3 |
| 11∼20 | 4 |
| 21∼30 | 4 |
| 31∼40 | 5 |
| 41∼50 | 5 |
| ABOVE 51 | 12 |

**TABLE 2**

| POROSITY (%) | RATE OF CHANGE IN OUTPUT VOLTAGE (%) |
|---|---|
| BELOW 4 | 13 |
| 5∼10 | 3 |
| 11∼20 | 5 |
| 21∼30 | 5 |
| 31∼40 | 6 |
| 41∼50 | 6 |
| ABOVE 51 | 18 |

**TABLE 3**

| SAMPLE No. | ELECTRODE MATERIAL | FORMING METHOD | OUTPUT DRIFT | |
|---|---|---|---|---|
| | | | MEAN VALUE (mV) | STANDARD DEVIATION σ |
| 1 | Ag-Pd | BAKING | 180 | 130 |
| 2 | Cu | VACUUM EVAPORATION | 80 | 29 |
| 3 | Ag | VACUUM EVAPORATION | 75 | 26 |
| 4 | Ni | ELECTROLESS PLATING | 60 | 23 |
| 5 | Cu-Ag | VACUUM EVAPORATION | 65 | 25 |
| 6 | Au | VACUUM EVAPORATION | 72 | 29 |

## Claims

1. Vibrating gyroscope comprising:
a vibrator (12) having a regular cross-section defined by at least three side surfaces; and
piezoelectric elements (14a,14b,14c), each of said piezoelectric elements (14a,14b,14c) being fixed to one of said at least three side surfaces and each of said piezoelectric elements (14a,14b,14c) comprising a piezoelectric body (16a,16b,16c) having electrodes (18a,20a,18b,20b,18c,20c) formed on both main surfaces thereof;
said piezoelectric body (16a,16b,16c) including pores such that its porosity is between 5% and 50%.

2. Vibrating gyroscope in accordance with claim 1, wherein said pores are formed by baking a piezoelectric ceramic material including an inflammable material and burning said inflammable material.

3. Vibrating gyroscope in accordance with claim 1, wherein said pores are formed by baking a foamed piezoelectric ceramic material.

4. Vibrating gyroscope in accordance with claim 1, wherein said pores are gaps between particles of a ceramic material, which are formed by controlling the particle size of said ceramic material.

5. Vibrating gyroscope in accordance with claim 1, wherein said pores are formed by baking a piezoelectric ceramic material in which gaps are formed by sticking a needle thereinto.

6. Vibrating gyroscope in accordance with any of claims 1 to 5, wherein each of said electrodes (18a,20a,18b,20b,18c,20c) is formed by vacuum evaporation.

7. Vibrating gyroscope in accordance with any of claims 1 to 5, wherein each of said electrodes (18a,20a,18b,20b,18c,20c) is formed by plating.

8. Vibrating gyroscope in accordance with claim 7, wherein said electrode is formed by electroless plating.

9. Vibrating gyroscope in accordance with any of claims 1 to 5, wherein each of said electrodes (18a,20a,18b,20b,18c,20c) is formed in a reticular shape.

## Patentansprüche

1. Vibrationsgyroskop mit folgenden Merkmalen:
einem Vibrator (12) mit einem regelmäßigen Querschnitt, der durch mindestens drei Oberflächen definiert ist; und
piezoelektrischen Elementen (14a, 14b, 14c), wobei jedes der piezoelektrischen Elemente (14a, 14b, 14c) an einer der mindestens drei Seitenoberflächen befestigt ist und wobei jedes der piezoelektrischen Elemente (14a, 14b, 14c) einen piezoelektrischen Körper (16a, 16b, 16c) mit Elektroden (18a, 20a, 18b, 20b, 18c, 20c), die auf beiden Hauptoberflächen desselben gebildet sind, aufweist;
wobei der piezoelektrische Körper (16a, 16b, 16c) Poren aufweist, derart, daß die Porosität desselben zwischen 5% und 50% liegt.

2. Vibrationsgyroskop gemäß Anspruch 1, bei dem die Poren durch Brennen eines piezoelektrischen Keramikmaterials, das ein brennbares Material aufweist, und durch Verbrennen des brennbaren Materials gebildet werden.

3. Vibrationsgyroskop gemäß Anspruch 1, bei dem die Poren durch Brennen eines geschäumten piezoelektrischen Keramikmaterials gebildet werden.

4. Vibrationsgyroskop gemäß Anspruch 1, bei dem die Poren Zwischenräume zwischen Partikeln eines Keramikmaterials sind, welche gebildet werden, indem die Partikelgröße des Keramikmaterials gesteuert wird.

5. Vibrationsgyroskop gemäß Anspruch 1, bei dem die Poren durch Brennen eines piezoelektrischen Keramikmaterials gebildet werden, indem durch Stechen einer Nadel in dasselbe Zwischenräume gebildet worden sind.

6. Vibrationsgyroskop gemäß einem beliebigen der Ansprüche 1 bis 5, bei dem jede der Elektroden (18a, 20a, 18b, 20b, 18c, 20c) durch Aufdampfen im Vakuum gebildet wird.

7. Vibrationsgyroskop gemäß einem beliebigen der Ansprüche 1 bis 5, bei dem jede der Elektroden (18a, 20a, 18b, 20b, 18c, 20c) durch Metallisieren gebildet wird.

8. Vibrationsgyroskop gemäß Anspruch 7, bei dem die Elektrode durch stromloses Metallisieren gebildet wird.

9. Vibrationsgyroskop gemäß einem beliebigen der Ansprüche 1 bis 5, bei dem jede der Elektroden (18a, 20a, 18b, 20b, 18c, 20c) in einer netzartigen Form gebildet ist.

## Revendications

1. Gyroscope vibratoire, comprenant :
un vibreur (12) ayant une section régulière définie par au moins trois surfaces latérales, et
des éléments piézoélectriques (14a, 14b, 14c), chacun desdits éléments piézoélectriques (14a, 14b, 14c) étant fixé sur l'une desdites au moins trois surfaces latérales et chacun desdits éléments piézoélectriques (14a, 14b, 14c) comprenant un corps piézoélectrique (16a, 16b, 16c) présentant des électrodes (18a, 20a, 18b, 20b, 18c, 20c) formées sur ses deux surfaces principales,
ledit corps piézoélectrique (16a, 16b, 16c) comportant des pores tels que sa porosité est comprise entre 5 % et 50 %.

2. Gyroscope vibratoire suivant la revendication 1, dans lequel lesdits pores sont formés par cuisson d'un matériau céramique piézoélectrique comportant un matériau inflammable et par calcination dudit matériau inflammable.

3. Gyroscope vibratoire suivant la revendication 1, dans lequel lesdits pores sont formés par cuisson d'un matériau céramique piézoélectrique mousse.

4. Gyroscope vibratoire suivant la revendication 1, dans lequel lesdits pores sont des ouvertures entre les particules d'un matériau céramique qui sont formées en réglant la grosseur de particule dudit matériau céramique.

5. Gyroscope vibratoire suivant la revendication 1, dans lequel lesdits pores sont formés par cuisson d'un matériau céramique piézoélectrique dans lequel des ouvertures sont formées en y introduisant une aiguille.

6. Gyroscope vibratoire suivant l'une quelconque des revendications 1 à 5, dans lequel chacune desdites électrodes (18a, 20a, 18b, 20b, 18c, 20c) et formée par évaporation sous vide.

7. Gyroscope vibratoire suivant l'une quelconque des revendications 1 à 5, dans lequel chacune desdites électrodes (18a, 20a, 18b, 20b, 18c, 20c) est formée par placage.

8. Gyroscope vibratoire suivant la revendication 7, dans lequel ladite électrode est formée par placage non-électrique.

9. Gyroscope vibratoire suivant l'une quelconque des revendications 1 à 5, dans lequel chacune desdites électrodes (18a, 20a, 18b, 20b, 18c, 20c) est formée de forme réticulaire.
